# EUROPEAN PATENT APPLICATION

(11) **EP 3 506 472 A1**
(43) Date of publication of application: **03.07.2019**
(21) Application number: 17842777.9
(22) Date of filing: 02.08.2017
(51) Int. Cl.: H02M 1/00, H05K 7/02

(54) **INTELLIGENT POWER MODULE, MOTOR CONTROLLER, AND VEHICLE**

(30) Priority: 24.08.2016 CN 201610718596
(71) Applicant: BYD Company Limited, Shenzhen, Guangdong 518118 (CN)
(72) Inventor: YANG, Xiaohua, Shenzhen Guangdong 518118 (CN); CHEN, Yin, Shenzhen Guangdong 518118 (CN); FANG, Linxia, Shenzhen Guangdong 518118 (CN)
(74) Representative: Ziebig & Hengelhaupt Patentanwälte PartG mbB
(86) International application number: PCT/CN2017/095722
(87) International publication number: WO 2018/036354

(57) **Abstract**

The present disclosure provides an intelligent power module, a motor controller and a vehicle. The intelligent power module includes a power electronic device, a capacitor electrically connected to the power electronic device, a driving board for driving the power electronic device, a first heat sink disposed between the power electronic device and the capacitor, and a fixing plate disposed on an outer side of the power electronic device, and the fixing plate is detachably connected to a side wall of the capacitor to clamp the power electronic device and the first heat sink between the fixing plate and the capacitor.

## Description

### FIELD

The present disclosure relates to the field of electric vehicles, and particularly to an intelligent power module, a motor controller having the intelligent power module and a vehicle having the motor controller.

### BACKGROUND

An IGBT module is a modular semiconductor device in which an IGBT (Insulated Gate Bipolar Transistor) and an FWD (Freewheeling Diode) are packaged by a specific circuit bridge connection. It mainly functions in rectification, inversion, frequency conversion, etc., and is widely used in the fields of rail transportation, home appliance energy conservation, wind power generation, solar photovoltaic and new energy vehicles (such as electric vehicles, etc.) and the like.

Typically, in the field of electric vehicles, an IGBT module is usually disposed in a motor controller to convert the direct current (DC) of a storage battery into an alternating current (AC) for driving a motor. The existing motor controller typically includes a box body, and an IGBT module, a film capacitor and a heat sink that are disposed in the box body. The arrangement of the components in the box is roughly the following structure:

The IGBT module is fixed on a bottom plate of the box body, an IGBT drive circuit board and an IGBT control circuit board are sequentially disposed above the IGBT module and connected to the IGBT module, the film capacitor is located on one side of the IGBT module and is also fixed on the box body, a side wall of the box body is provided with a DC terminal for electrically connecting the storage battery and an AC terminal for electrically connecting the motor, and a direct-current terminal of the IGBT module is connected to a direct-current terminal of the film capacitor, and the IGBT module and the film capacitor are electrically connected in parallel to the DC terminal. In addition, the IGBT module is also connected to the AC terminal to output alternating-current power to the motor. Further, a fluid passage for a cooling medium to flow through is disposed in the bottom plate of the box body to help the IGBT module to dissipate heat.

However, such a motor controller is often limited by the above-described structural arrangement. Since the IGBT module and the film capacitor are respectively fixed at two positions of the bottom plate and vibration occurs during the operation of the motor controller, when the amplitude between the IGBT module and the film capacitor is different, a relative displacement occurs between them, so that a large stress is generated between the direct-current terminal of the IGBT module and the direct-current terminal of the film capacitor, which easily causes the electrical connection to loosen and even results in that the motor controller cannot operate normally.

### SUMMARY

The present disclosure is directed to an intelligent power module, a motor controller and a vehicle to avoid electrical connection failure between an IGBT module and a capacitor caused by relative displacement between the IGBT module and the capacitor in a vibration process, thereby ensuring the normal operation of the intelligent power module.

In order to achieve the above object, the present disclosure provides an intelligent power module, where the intelligent power module includes a power electronic device, a capacitor electrically connected to the power electronic device, a driving board for driving the power electronic device, a first heat sink disposed between the power electronic device and the capacitor, and a fixing plate disposed on an outer side of the power electronic device, and the fixing plate is detachably connected to a side wall of the capacitor to clamp the power electronic device and the first heat sink between the fixing plate and the capacitor.

Based on the above technical solution, the present disclosure further provides a motor controller. The motor controller includes a box body, where the motor controller further includes the intelligent power module provided in the present disclosure and a control board for controlling the power electronic device of the intelligent power module that are disposed in the box body, the control panel is electrically connected to a driving board of the intelligent power module, and a capacitor of the intelligent power module is fixed in the box body.

Based on the above technical solution, the present disclosure further provides a vehicle, where the vehicle includes the motor controller provided in the present disclosure.

Through the above technical solution, the intelligent power module provided in the present disclosure fixes the power electronic device, the first heat sink and the capacitor as a whole by means of the fixing plate, so the relative displacement between the power electronic device and the capacitor is not generated during the operation of the intelligent power module, thereby ensuring the electrical connection between the power electronic device and the capacitor, so that the intelligent power module may operate normally. Since the motor controller and the vehicle provided in the present disclosure include the intelligent power module provided in the present disclosure, the above advantages are also obtained.

Other features and advantages of the present disclosure are described in detail in the Detailed Description part below.

### BRIEF DESCRIPTION OF THE DRAWINGS

Accompanying drawings are used to provide further understanding on the present disclosure, constitute a part of this specification, and are used, together with the following specific implementations, to explain the present disclosure, but do not constitute limitations to the present disclosure. In the accompanying drawings: In the figures:
FIG. 1 is a three-dimensional view of an intelligent power module provided according to a specific implementation of the present disclosure;
FIG. 2 is an exploded view of an intelligent power module provided according to a specific implementation of the present disclosure, in which a capacitor is not shown;
FIG. 3 is a three-dimensional view of a capacitor of an intelligent power module provided according to a specific implementation of the present disclosure, and in the illustrated specific implementation, a wave plate member is assembled between a second heat sink and a fixing plate;
FIG. 4 is a three-dimensional view of a wave plate member of an intelligent power module provided according to a specific implementation of the present disclosure;
FIG. 5 is a schematic cross-sectional view of a fixing plate of an intelligent power module provided according to a specific implementation of the present disclosure;
FIG. 6 is a three-dimensional view of a buckle of an intelligent power module provided according to a specific implementation of the present disclosure;
FIG. 7 is a three-dimensional view of a fixing plate of an intelligent power module provided according to a specific implementation of the present disclosure;
FIG. 8 is a three-dimensional view of a fixing plate of an intelligent power module provided according to another specific implementation of the present disclosure; and
FIG. 9 is a three-dimensional view of a motor controller provided according to an implementation of the present disclosure, in which a box body is not shown to avoid obscuring components disposed inside the box body.

### Reference numerals:

10: Intelligent power module;
11: Power electronic device;
12a: First heat sink; 12b: Second heat sink;
14: Capacitor; 14a: Fixing leg;
15a: Input tube; 15b: Output tube;
17: Fixing tab;
18: Fixing plate; 18a: Limiting groove;
19: Wave plate member;
20a: Buckle; 20b: Snap-in hole; 20a1: Extending portion; 20a2: Locking portion;
21: Ear plate; and 21a: Connecting portion.

### DETAILED DESCRIPTION

Specific implementations of the present disclosure are described in detail below. It should be understood that the specific implementations described herein are merely used to describe and explain the present disclosure rather than limiting the present disclosure.

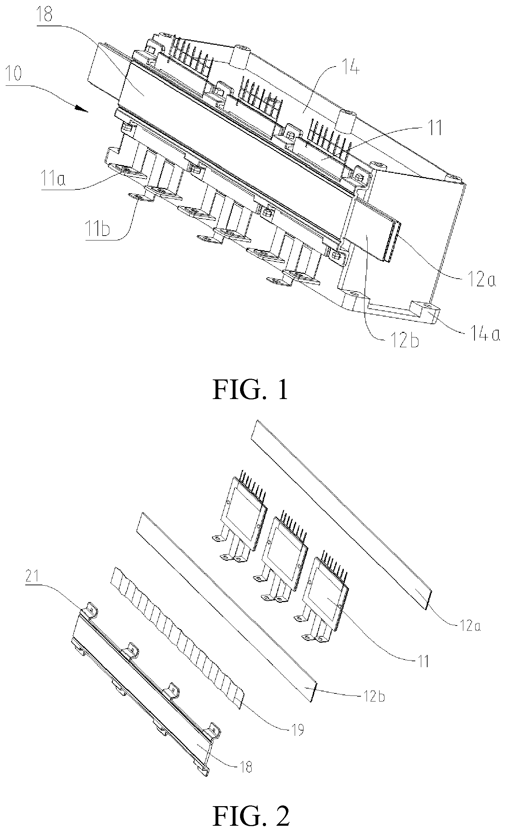

In the present disclosure, the term "side surface" or "side face" used in the present disclosure is a side surface or side face of a corresponding component in FIG. 1 without the contrary description; the "length direction" and "height direction" used are defined on the basis of the left-right direction and the up-down direction in FIG. 1, and are merely for explaining the present disclosure and are not intended to be limiting.

According to a specific implementation of the present disclosure, an intelligent power module 10 is provided. Referring to FIG. 1, the intelligent power module 10 includes a power electronic device 11, a capacitor 14 electrically connected to the power electronic device 11, a driving board for driving the power electronic device 11, a first heat sink 12a disposed between the power electronic device 11 and the capacitor 14, and a fixing plate 18 disposed on an outer side of the power electronic device 11, and the fixing plate 18 is detachably connected to a side wall of the capacitor 14 to clamp the power electronic device 11 and the first heat sink 12a between the fixing plate 18 and the capacitor 14.

It should be noted herein that for the power electronic device 11, the fixing plate 18 and the capacitor 14 are respectively located on two sides thereof, and the "outer side" herein refers to the other side opposite to a side on which the capacitor 14 is located.

The intelligent power module 10 according to the embodiment of the present disclosure fixes the power electronic device 11, the first heat sink 12a and the capacitor 14 as a whole by the fixing plate 18, so the relative displacement between the power electronic device 11 and the capacitor 14 is not generated during the operation of the intelligent power module 10, thereby ensuring the electrical connection between the power electronic device 11 and the capacitor 14, so that the intelligent power module 10 may operate normally.

During operation of the intelligent power module 10, the power electronic device 11 and the capacitor 14 generate a certain amount of heat, causing their own temperature to rise. However, the higher temperature easily affects its own normal operation, or even damages itself, and therefore, in the intelligent power module 10 according to the embodiment of the present disclosure, the first heat sink 12a disposed between the power electronic device 11 and the capacitor 14 is capable of simultaneously performing heat exchange with the power electronic device 11 and the capacitor 14, thereby simultaneously reducing the temperatures of the two.

In the above case, in order to ensure the fixing effect of the power electronic device 11, a first elastic member may be disposed between the first heat sink 12a and the capacitor 14, so that when the fixing plate 18 is connected to the capacitor 14, the first elastic member is simultaneously pressed by the first heat sink 12a and the capacitor 14, and resulting elastic force presses the first heat sink 12a toward the power electronic device 11. Accordingly, the first heat sink 12a may have elasticity, so that when the first elastic member is pressed to be deformed, the first heat sink 12a may also be deformed under the action of the first elastic member. Therefore, the deformation of the first heat sink 12a and the deformation of the first elastic member simultaneously provide the power electronic device 11 with a pretightening force capable of clamping the power electronic device 11 between the fixing plate 18 and the first heat sink 12a, and may prevent the power electronic device 11 from being pressed and deformed to some extent. Therefore, in the case where the first heat sink 12a is disposed, the power electronic device 11 is clamped between the fixing plate 18 and the first heat sink 12a.

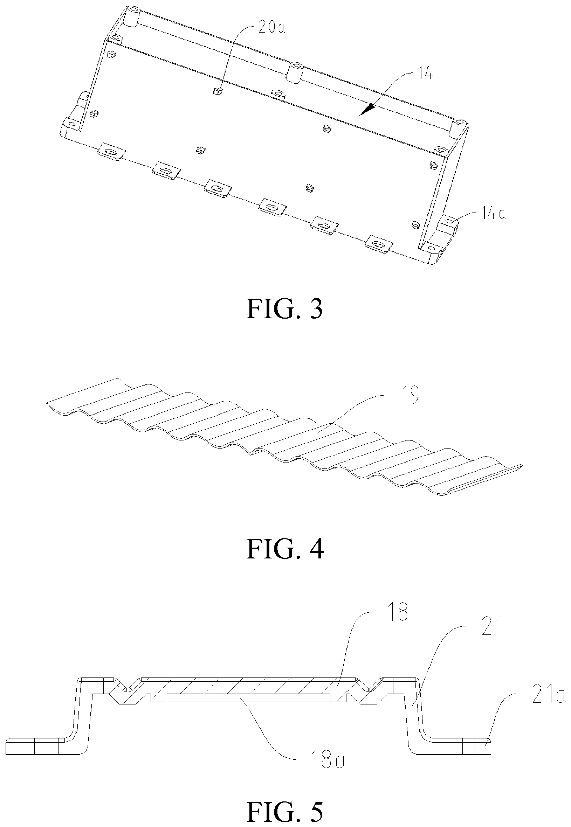

In the above implementation (which is not shown in the drawings), the first elastic member may be an elastic member having any suitable structure. For example, referring to FIG. 4, the first elastic member is a wave plate member 19. When the wave plate member 19 is assembled between the first heat sink 12a and the capacitor 14, crests (or troughs) of the wave plate member 19 are pressed against a side face, facing the capacitor 14, of the first heat sink 12a. Correspondingly, the troughs (or crests) of the wave plate member 19 are pressed against a side wall, facing the first heat sink 12a (which can also be understood as facing the power electronic device 11), of the capacitor 14, thereby increasing the stress positions of the first heat sink 12a (the positions where the wave plate member 19 is in line contact with the first heat sink 12a). The size, the peak and trough density, the strength, and the like of the wave plate member 19 may be selected according to actual needs, so that the force density (the number of the stress positions per unit area) of the first heat sink 12a may be determined. Generally, the greater the force density is, the more uniform and stable force on the first heat sink 12a is. In this case, the first heat sink 12a may be a flat tube such that the wave plate member 19 and the first heat sink 12a are in line contact or in surface contact. Since the pressure transmitted through the line contact or the surface contact is more uniform and more stable, the pressure generated between the wave plate member 19 and the first heat sink 12a may be more uniformly and stably transmitted to the power electronic device 11 via the first heat sink 12a, that is, the more uniform and more stable pressure transmitted through the line contact or the surface contact is transmitted to the power electronic device 11 through the surface contact between the first heat sink 12a and the power electronic device 11, therefore, the pressure may be used as clamping force for clamping the power electronic device 11, and it is possible to avoid the failure of the power electronic device 11 due to stress concentration.

In the above specific implementation, a first limiting structure may be disposed on at least one of two opposite side surfaces of the first heat sink 12a and the capacitor 14 to retain the first elastic member between the first heat sink 12a and the capacitor 14. Herein, the first limiting structure may be in any suitable form, for example, a limiting block or a limiting strip protruding from the corresponding side face, or a limiting groove on the corresponding side face.

In a preferred implementation of the present disclosure, the intelligent power module 10 further includes a second heat sink 12b disposed between the power electronic device 11 and the fixing plate 18 for heat exchange with the power electronic device 11, thereby improving the heat dissipation effect of the power electronic device 11. The second heat sink 12b may have elasticity, so that in the case where the fixing plate 18 is connected to the capacitor 14, the second heat sink 12b may be deformed under the action of the fixing plate 18 to press the power electronic device 11 toward the first heat sink 12a, thereby providing a pretightening force capable of clamping the power electronic device 11 between the first heat sink 12a and the second heat sink 12b. Further, by connecting the fixing plate 18 to the capacitor 14, the power electronic device 11, the first heat sink 12a and the second heat sink 12b may be fixed together to the capacitor 14, and the power electronic device 11, the first heat sink 12a and the second heat sink 12b may be clamped between the fixing plate 18 and the capacitor 14 by the fixing plate 18. In this case, the fixing plate 18, the power electronic device 11, the first heat sink 12a, the second heat sink 12b and the capacitor 14 are integrated as a whole, and may prevent the power electronic device 11 from being pressed and deformed to some extent. Therefore, in the case where the first heat sink 12a and the second heat sink 12b are disposed, the power electronic device 11 is clamped between the first heat sink 12a and the second heat sink 12b.

In the above case, in order to ensure the fixing effect of the power electronic device 11, a second elastic member may be disposed between the second heat sink 12b and the fixing plate 18. When the fixing plate 18 is connected to the capacitor 14, the second elastic member is simultaneously pressed by the second heat sink 12b and the fixing plate 18, and resulting elastic force presses the second heat sink 12b toward the power electronic device 11. At the same time, the second heat sink 12b is also deformed under the action of the pressure of the second elastic member, and the resulting elastic force is used as the pretightening force for clamping the power electronic device 11 between the first heat sink 12a and second heat sink 12b, and may well and even completely prevent the power electronic device 11 from being pressed and deformed.

The second elastic member may be an elastic member having any suitable structure. For example, referring to FIG. 4, the second elastic member is a wave plate member 19. Referring to FIG. 2, when the wave plate member 19 is assembled between the second heat sink 12b and the fixing plate 18, crests (or troughs) of the wave plate member 19 are pressed against a side face, facing the fixing plate 18, of the second heat sink 12b. Correspondingly, the troughs (or crests) of the wave plate member 19 are pressed against a side wall, facing the second heat sink 12b (which can also be understood as facing the power electronic device 11), of the fixing plate 18, thereby increasing the stress positions of the second heat sink 12b (the positions where the wave plate member 19 is in line contact with the second heat sink 12b). The size, the peak and trough density, the strength, and the like of the wave plate member 19 may be selected according to actual needs, so that the force density (the number of the stress positions per unit area) of the second heat sink 12b may be determined. Generally, the greater the force density is, the more uniform and stable force on the second heat sink 12b is. In this case, the second heat sink 12b may be a flat tube such that the wave plate member 19 and the second heat sink 12b are in line contact or in surface contact. Since the pressure transmitted through the line contact or the surface contact is more uniform and more stable, the pressure generated between the wave plate member 19 and the second heat sink 12b may be more uniformly and stably transmitted to the power electronic device 11 via the second heat sink 12b, that is, the more uniform and more stable pressure transmitted through the line contact or the surface contact is transmitted to the power electronic device 11 through the surface contact between the second heat sink 12b and the power electronic device 11, so that the pressure may be used as the clamping force for clamping the power electronic device 11, and therefore, it is possible to avoid the failure of the power electronic device 11 due to stress concentration.

A second limiting structure is disposed on at least one of two opposite side surfaces of the second heat sink 12b and the fixing plate 18 to retain the second elastic member between the second heat sink 12b and the fixing plate 18. Herein, the second limiting structure may be in any suitable form, for example, a limiting block or a limiting strip protruding from the corresponding side face, or a limiting groove on the corresponding side face.

For example, referring to FIG. 5, the second limiting structure is disposed on the side face, facing the second heat sink 12b, of the fixing plate 18, and the second limiting structure is formed into a limiting groove 18a for accommodating the second elastic member.

In another implementation of the present disclosure, the first elastic member and the second elastic member may be disposed at the same time.

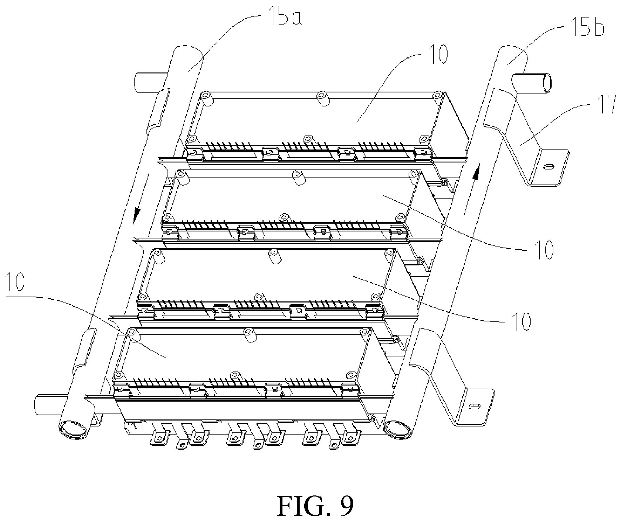

In the above preferred implementation, the first heat sink 12a and the second heat sink 12b may be fluidly connected in parallel between an input tube 15a and an output tube 15b for the flow of a cooling medium (for example, water, air, etc.). Thus, heat of the power electronic device 11 and the capacitor 14 may be carried away by the flow of the cooling medium in the direction of an arrow in FIG. 9, thereby lowering the temperatures of the two. The input tube 15a and the output tube 15b are disposed in parallel to each other, and the capacitor 14 is located between the input tube 15a and the output tube 15b, so that the structure of the intelligent power module 10 may be compact, and the volume of the intelligent power module 10 may be reduced.

In a specific implementation of the present disclosure, in order to facilitate the disassembly and assembly of the fixing plate 18, the fixing plate 18 may be clamped to the capacitor 14.

In order to achieve the above snap joint, the fixing plate 18 may be provided with one of a buckle 20a and a snap-in hole 20b that can be matched with each other, and the capacitor 14 may be provided with the other of the buckle 20a and the snap-in hole 20b that can be matched with each other.

Referring to FIG. 1, FIG. 2, FIG. 6 and FIG. 7, the buckle 20a is disposed on a side wall of the capacitor 14 facing the power electronic device, two opposite edges of the fixing plate 18 are respectively provided with a plurality of ear plates 21 extending toward the capacitor 14 at intervals, one end, away from the fixing plate 18, of the ear plate 21 is bent to form a connecting portion 21a, and the snap-in hole 20b is formed in the connecting portion 21a. In order to improve the fixing effect of the fixing plate 18 and to make the clamping force of the fixing plate 18 to the power electronic device 11 uniform, the ear plates 21 are disposed at uniform intervals. As shown in FIG. 1, FIG. 2, FIG. 7 and FIG. 8, eight groups of buckles 20a and snap-in holes 20b may be disposed, and correspondingly, the two opposite edges of the fixing plate 18 are respectively provided with four groups.

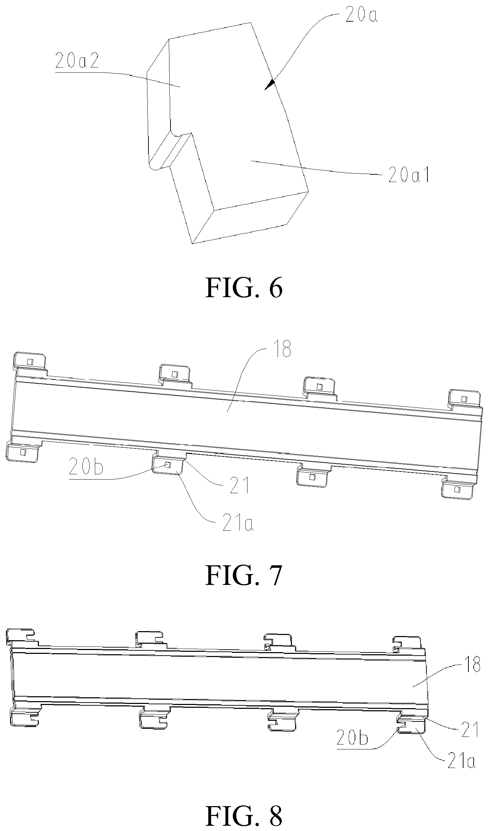

As shown in FIG. 6, the buckle 20a includes an extending portion 20al for connection (for example, connected to a side wall of the capacitor 14, as shown in FIG. 1 and FIG. 3) and a locking portion 20a2 located at a tail end of the extending portion 20a1. In order to ensure the snap-joint fixing, among the corresponding four groups of the buckles 20a and the snap-in holes 20b respectively located on the two edges of the fixing plate 18, the postures of two groups of buckles 20a are mirrored with the postures of the other two groups of buckles.

In addition, in order to lock the buckle 20a, the snap-in hole 20b may be formed into a square hole (as shown in FIG. 7) or opening (as shown in FIG. 8). The extending portion 20a1 has elasticity, and therefore, the extending portion 20a1 may be deformed during the passage of the locking portion 20a2 through the snap-in hole 20b, so that the locking portion 20a2 may smoothly pass through the snap-in hole 20b and be locked on the ear plate 21.

In addition, in the specific implementation provided in the present disclosure, the capacitor 14 may have any desired shape. Preferably, the capacitor 14 is in the shape of a rectangular parallelepiped as shown in FIG. 1 and FIG. 3, and the length direction and height direction thereof are respectively parallel to the length direction and height direction of the power electronic device 11. In another specific implementation of the present disclosure, the capacitor 14 may also have other shapes, such as a cylindrical shape, and the axial direction of the cylindrical capacitor 14 may be parallel to the length direction of the power electronic device; and an outer surface of the first heat sink 12a may be formed in a curved shape matched with an outer surface of the cylindrical capacitor 14 to facilitate as much and close contact as possible with the outer surface of the capacitor 14.

Further, in a preferred implementation of the present disclosure, the power electronic device 11 may be an IGBT module. The capacitor 14 may be a film capacitor. In practical applications, the number of IGBT modules may be selected according to the required power. Therefore, in the specific implementation provided in the present disclosure, there may be one IGBT module or a plurality of IGBT modules connected in parallel. For example, in the specific implementation shown in FIG. 1 and FIG. 2, there are three IGBT modules connected in parallel. Each IGBT module includes a direct-current connection end and a three-phase alternating-current connection end, and the direct-current connection end of each IGBT module is connected in parallel to a direct-current connection port of the capacitor 14 (i.e., a positive connection port and a negative connection port) through fasteners so as to connect a direct-current power supply, such as a storage battery. The three-phase alternating-current connection end of each IGBT module is used to output alternating-current power after converting direct-current power to the alternating-current power through the IGBT module. In addition, in order to facilitate the connection between the direct-current connection end of the IGBT module and the direct-current connection port of the capacitor 14 and to fix the IGBT module relative to the capacitor 14 by means of the connection, a spacer may be disposed between the direct-current connection end of the IGBT module and the capacitor 14, so that the direct-current connection end of the IGBT module may be connected to the direct-current connection port of the capacitor 14 by passing the fastener (e.g., a bolt or a screw) through the spacer.

Based on the above technical solution, the present disclosure further provides a motor controller including a box body. The motor controller further includes an intelligent power module 10 according to the embodiment of the present disclosure and a control board for controlling the power electronic device 11 that are disposed in the box body, the control board is electrically connected to the driving board, and the capacitor 14 is fixed to the box body. For example, as shown in FIG. 3, the capacitor 14 is provided with fixing legs 14a at four corners, and the fixing legs 14a are provided with fixing holes for cooperating with fasteners (e.g., screws) to fix the capacitor 14 to the box body.

In the motor controller according to the embodiment of the present disclosure, referring to FIG. 9, a plurality of intelligent power modules 10 may be disposed. The plurality of intelligent power modules 10 are disposed in parallel to provide required power, and share the same group of input tube 15a and output tube 15b, and the input tube 15a and the output tube 15b may be fixed onto the box body through fixing tabs 17. Therefore, the intelligent power module 10 according to the embodiment of the present disclosure has the advantage of easy expansion.

In addition, when the power electronic device 11 is an IGBT module, the box body is provided with a direct-current terminal and an alternating-current terminal, the capacitor and the IGBT module in the intelligent power module are connected in parallel between a positive electrode and a negative electrode of the direct-current terminal through a direct-current wire, and three-phase alternating-current connection ends of the IGBT modules in each of the intelligent power modules are connected through a three-phase alternating-current wire so as to be connected to the alternating-current terminal.

In the above specific implementation, the direct-current wire and the three-phase alternating-current wire are both copper strips, and therefore, not only function as electrical connections, but also have a certain fixing function.

Based on the above technical solution, the present disclosure further provides a vehicle. The vehicle includes the motor controller provided in the present disclosure.

Although specific implementations of the present disclosure are described in detail above, the present disclosure is not limited to specific details in the foregoing implementations. Various simple variations can be made to the technical solutions of the present disclosure within the scope of the technical idea of the present invention, and such simple variations all fall within the protection scope of the present disclosure.

It should also be noted that specific technical features described in the foregoing specific implementations may be combined in any appropriate manner without conflict. To avoid unnecessary repetition, various possible combination manners are not further described in the disclosure.

In addition, various different implementations of the present disclosure may alternatively be combined randomly. Such combinations should also be considered as the content disclosed in the present disclosure provided that these combinations do not depart from the concept of the present disclosure.

## Claims

1. An intelligent power module (10), wherein the intelligent power module (10) comprises a power electronic device (11), a capacitor (14) electrically connected to the power electronic device (11), a driving board for driving the power electronic device (11), a first heat sink (12a) disposed between the power electronic device (11) and the capacitor (14), and a fixing plate (18) disposed on an outer side of the power electronic device (11), and the fixing plate (18) is detachably connected to a side wall of the capacitor (14) to clamp the power electronic device (11) and the first heat sink (12a) between the fixing plate (18) and the capacitor (14).

2. The intelligent power module (10) according to claim 1, wherein a first elastic member is disposed between the first heat sink (12a) and the capacitor (14).

3. The intelligent power module (10) according to claim 2, wherein the first elastic member is a wave plate member (19), and the first heat sink (12a) is a flat tube.

4. The intelligent power module (10) according to claim 2, wherein a first limiting structure is disposed on at least one of two opposite side surfaces of the first heat sink (12a) and the capacitor (14) to retain the first elastic member between the first heat sink and the capacitor.

5. The intelligent power module (10) according to claim 1, wherein the intelligent power module (10) further comprises a second heat sink (12b) disposed between the power electronic device (11) and the fixing plate (18), and a second elastic member is disposed between the second heat sink (12b) and the fixing plate (18).

6. The intelligent power module (10) according to claim 5, wherein the second elastic member is a wave plate member (19), and the second heat sink (12b) is a flat tube.

7. The intelligent power module (10) according to claim 5, wherein a second limiting structure is disposed on at least one of two opposite side surfaces of the second heat sink (12b) and the fixing plate (18) to retain the second elastic member between the second heat sink and the fixing plate.

8. The intelligent power module (10) according to claim 7, wherein the second limiting structure is disposed on a side surface, facing the second heat sink (12b), of the fixing plate (18), and the second limiting structure is formed into a limiting groove (18a) for accommodating the second elastic member.

9. The intelligent power module (10) according to claim 5, wherein the first heat sink (12a) and the second heat sink (12b) are fluidly connected in parallel between an input tube (15a) and an output tube (15b), the input tube (15a) and the output tube (15b) are disposed in parallel to each other, and the capacitor (14) is located between the input tube (15a) and the output tube (15b).

10. The intelligent power module (10) according to claim 5, wherein a first elastic member is disposed between the first heat sink (12a) and the capacitor (14).

11. The intelligent power module (10) according to any one of claims 1-10, wherein the fixing plate (18) is clamped to the capacitor (14).

12. The intelligent power module (10) according to claim 11, wherein the fixing plate (18) is provided with one of a buckle (20a) and a snap-in hole (20b) that may be matched with each other, and the capacitor (14) is provided with the other of the buckle (20a) and the snap-in hole (20b) that may be matched with each other.

13. The intelligent power module (10) according to claim 12, wherein the buckle (20a) is disposed on a side wall of the capacitor (14) facing the power electronic device (11), two opposite edges of the fixing plate (18) are respectively provided with a plurality of ear plates (21) extending toward the capacitor (14) at intervals, one end, away from the fixing plate (18), of the ear plate (21) is bent to form a connecting portion (21a), and the snap-in hole (20b) is formed in the connecting portion (21a).

14. The intelligent power module (10) according to claim 13, wherein the plurality of ear plates (21) are arranged at uniform intervals.

15. The intelligent power module (10) according to claim 11, wherein the power electronic device (11) is an IGBT module.

16. A motor controller, comprising a box body, wherein the motor controller further comprises the intelligent power module (10) according to any one of claims 1 to 15 and a control board for controlling a power electronic device (11) of the intelligent power module (10) that are disposed in the box body, the control panel is electrically connected to a driving board of the intelligent power module (10), and a capacitor (14) of the intelligent power module (10) is fixed in the box body.

17. A vehicle, comprising a storage battery and a motor, wherein the vehicle comprises the motor controller according to claim 16, and the motor controller is electrically connected between the storage battery and the motor.
